# EUROPÄISCHE PATENTSCHRIFT

(11) **EP 1 321 969 B1**
(45) Veröffentlichungstag und Bekanntmachung des Hinweises auf die Patenterteilung: **02.03.2005**
(21) Anmeldenummer: 02026853.8
(22) Anmeldetag: 30.11.2002
(51) Int. Cl.: H01L 21/00

(54) **Verfahren und Vorrichtung zum Handhaben von Halbleiterscheiben**
Method and apparatus for handling semiconductor wafers
Procédé et dispositif de manipulation de plaquettes semiconductrices

(30) Priorität: 17.12.2001 DE 10161902
(43) Veröffentlichungstag der Anmeldung: 25.06.2003
(73) Patentinhaber: Infineon Technologies AG, 81669 München (DE)
(72) Erfinder: Binder, Alfred, 9500 Landskron (AT); Hiebler, Gunter, 9500 Villach (AT); Kroupa, Gerhard, 9500 Villach (AT); Matschitsch, Martin, 9181 Feistritz i. Ros. (AT); Pucher, Gerhard, 9500 Villach (AT)
(74) Vertreter: Kindermann, Peter, Dipl.-Ing.

(56) Entgegenhaltungen:
- WO-A-99/17244
- DE-A- 19 948 572
- US-A- 3 930 684
- US-A- 6 095 582
- PATENT ABSTRACTS OF JAPAN vol. 015, no. 065 (M-1082), 15. Februar 1991 (1991-02-15) -& JP 02 292196 A (NIDEK CO LTD), 3. Dezember 1990 (1990-12-03)
- PATENT ABSTRACTS OF JAPAN vol. 1999, no. 11, 30. September 1999 (1999-09-30) -& JP 11 165869 A (SAMSUNG ELECTRON CO LTD), 22. Juni 1999 (1999-06-22)
- PATENT ABSTRACTS OF JAPAN vol. 2000, no. 12, 3. Januar 2001 (2001-01-03) -& JP 2000 243814 A (ULVAC JAPAN LTD), 8. September 2000 (2000-09-08)

## Beschreibung

Die vorliegende Erfindung betrifft ein Verfahren und eine Vorrichtung zum Handling von Platten, insbesondere von Halbleiterscheiben, die an einem ersten Ort aufzunehmen und in ihrer Lage zu verändern oder zu einem zweiten Ort zu transportieren sind.

Halbleiterscheiben oder -wafer sind bekanntlich sehr dünn und weisen bei einem Durchmesser in der Größenordnung von 2 bis 8 Zoll Scheibendicken auf, die in der Größenordnung von einigen 10 bis einigen 100 µm liegen. Solche Halbleiterscheiben werden bisher zumeist manuell bzw. mit einem Handlingsystem von einem ersten Prozessierungsort zu einem zweiten Prozessierungsort gebracht. In der Praxis werden beispielsweise durch das Dünnschleifen ungewollt oft verbogene Halbleiterscheiben erzeugt, die sowohl konkave als auch konvexe Krümmungen enthalten. Diese Halbleiterscheiben können durch das Handlingsystem nicht mehr problemfrei gehandhabt werden. Daher werden sie im allgemeinen manuell mit Hilfe einer Pinzette aus einem entsprechenden Behälter entnommen und zur weiteren Prozessierung beispielweise in ein sogenanntes Quarz-Boot gebracht. Ein Quarz-Boot ist eine bestimmte Aufbewahrungskassette für Halbleiterscheiben. Der Einsatz einer Pinzette ist aber nicht unproblematisch, da dieser leicht zu partiellen Beschädigungen, wie der Entstehung von Haarrissen und damit zu einem Ausfall von Chips in dem entsprechenden Bereich der Halbleiterscheibe führen kann.

Das Entnehmen und Einfügen von mechanisch wenig belastbaren Wafern aus oder in Materialträger (die bereits genannten Quarz-Boote, Kunststoffhorden o. ä.)muss zudem ohne Kantenkontakt mit diesen Behältern erfolgen, da bei Kantenkontakt sowohl die dünnen Wafer als auch die Behälter beschädigt würden, denn derartig dünne Wafer sind Rasierklingen ähnlich scharf.

Durch punktuelle Aufnahme mittels herkömmlicher Pinzetten ist der dünne Wafer nicht ausreichend unterstützt. Daher neigt ein so gehandhabter Wafer über die bereits erwähnten Probleme hinaus leicht zum Schwingen. Die Waferverbiegung hervorgerufen durch Verspannung des Wafers erschwert die Be- und Entstückung für den Operator. Die scharfen Kanten der Wafer schneiden in den schmalen Schlitzen der Behälter in die Materialstege und das führt unweigerlich zum Bruch des Wafers und zu Beschädigungen am Behälter.

Aus der DE 199 48 572 A1 ist eine sogenannte pneumatische Pinzette zur Handhabung von Dünnwafern bekannt. Die dort gezeigte und beschriebene Pinzette weist einen als Düsenplatte ausgebildeten Teller auf, welcher in seinem Zentrum eine Vakuumbohrung aufweist, und der am Umfang zahlreiche Düsenbohrungen enthält, die zur Erzeugung eines sogenannten Bernoulli-Prinzips dienen, welches auch als Bernoulli-Effekt bekannt ist. Unter diesem Bernoulli-Effekt ist die Bildung eines hydrodynamischen Unterdrucks zu verstehen, welcher dadurch entsteht, dass aus dem Zentrum einer Düsenplatte Gas durch nach außen gerichtete Düsen in die Randbereiche der Düsenplatte strömt und dabei im Zentrum ein geringerer Luftdruck herrscht, als in den Außenbereichen, in welche das Gas vom Zentrum aus strömt. Dünne Waferscheiben können mit einer derartigen pneumatischen Pinzette, deren Funktion auf dem vorbeschriebenen Effekt beruht, verhältnismäßig gut gehandhabt werden, da die Kombination von Bernoulli-Effekt und Vakuum als berührungslose Halteelemente für Waferscheiben entscheidende Vorteile hat.

Trotz dieser relativ guten Handhabung ist nachteilig, dass dünne Wafer immer noch manuell in den verschiedenen Materialträgern wie Horden, Booten und dergleichen be- und entladen werden müssen. Obwohl die Be -und Entladung nur von speziell geschultem Personal durchgeführt wird, ist die Bruchrate beim manuellen Handling immer noch entsprechend hoch. Die höchst sensiblen Bewegungsabläufe der einzelnen Vorgänge können nur unter großem persönlichen Einsatz des Operators durchgeführt werden. Entsprechend hoch ist der Zeitaufwand für diese Arbeitsgänge beim manuellen Dünnwaferhandling.

WO99/17244 offenbart eine Greifvorrichtung zum vakuumgestützten Halten einer Halbleiterscheibe. Die Greifvorrichtung ist mehrteilig ausgeführt und hat Düsenbohrungen zur Vakuum halterung. Weiterhin wird eine drehbare Halterung offenbart, die eine Halbleiter scheibe nach Mußgabe von Sensorsignalen in eine vorbestimmte Position bewegen Kann.

Auf automatisches Dünnwaferhandling musste bisher verzichtet werden, da die Wafer weder zentriert noch geebnet - was in der Fachsprache auch als "geflatet" bezeichnet wird - in den Materialträgern abgelegt waren, wodurch eine kontrollierte Entnahme der verbogenen und unzentrierten Wafer nicht gewährleistet war. Die Ausrichtung der Wafer - damit ist ihre vorbestimmbare Positionierung in einer definierten Position gemeint - wurde bisher mit sogenannten "Standard Flat Aligner" durchgeführt, die jedoch für Dünnwafer nicht geeignet sind.

Ebenfalls sind sogenannte Greifer mit Zentrierpins für das Hordenhandling ungeeignet, da ihre Bauhöhe, bedingt durch die Zentrierpins, zu groß ist.

Demgegenüber ist es Aufgabe der vorliegenden Erfindung, ein Verfahren zum selbsttätigen, d.h. automatischen Handling von Platten, beispielsweise Halbleiterscheiben anzugeben, das ein sicheres Justieren und Handhaben der Halbleiterscheiben, wie beispielsweise eine Zentrierung und definierte Ausrichtung bei der Be- und Entstückung in bzw. aus Behältern erlaubt.

Ferner ist es Aufgabe der vorliegenden Erfindung, eine Vorrichtung zum selbsttätigen, d.h. automatischen Handling von Platten, beispielsweise Halbleiterscheiben zu schaffen, die ein sicheres Positionieren und Handhaben der Halbleiterscheiben beim Be- und Entladen von Behältern erlaubt, wobei die Vorrichtung eine möglichst geringe Bauhöhe aufweisen und an jeder Art von gebräuchlichem Handhabungsautomaten (Roboter) einsetzbar sein soll.

Diese Aufgabe wird durch ein Verfahren mit den Merkmalen des Anspruchs 1 gelöst.

Besonders vorteilhaft ist es, die Schritte folgendermaßen ablaufen zu lassen:
a. eine Greifvorrichtung fährt im Wesentlichen parallel zu einer Scheibe in den Materialträger;
b. mittels pneumatischer Hilfe wird die Scheibe geebnet und durch Zentrierelemente im Greifer zentriert;
c. mittels Vakuum wird die Scheibe im Greifer auf einer Halterung fixiert;
d. die Zentrierelemente werden von der Scheibe gelöst;
e. mittels Halterung wird die Scheibe gedreht;
f. die Position der Scheibe wird durch Sensoren erfasst;
g. bei Erreichen einer vorbestimmbaren Position wird die Drehung der Scheibe gestoppt;
h. die geebnete und exakt positionierte Scheibe wird in einem Materialträger beliebiger Art abgelegt.

Mit diesen Verfahrensschritten ist ein automatisches Handling von Dünnwafern möglich, welches die Bearbeitungszeiten und die Fehlerrate deutlich reduziert.

Wenn die Erfassung der Drehung der Halbleiterscheibe durch mehrere als Fühler ausgebildete Sensoren sukzessive erfolgt, kann die daraus abgeleitete Drehgeschwindigkeit individuell angepasst werden, was die Genauigkeit der Positionierung erhöht und den Fertigungsprozess zu optimieren hilft.

Der die Vorrichtung betreffende Aufgabenteil wird mit einer Vorrichtung der eingangs genannten Art erfindungsgemäß durch eine Haltevorrichtung gelöst, deren Merkmale dem Anspruch 4 zu entnehmen sind. Vorteilhafte Ausgestaltungen der Haltevorrichtung sind den abhängigen Ansprüchen zu entnehmen.

Besonders vorteilhaft ist es, wenn die Haltevorrichtung mehrteilig ausgeführt ist und zumindest im Zentrum Düsenbohrungen zum hydrodynamischen Halten der Halbleiterscheibe aufweist, und wenn Zentrierelemente zum zentrierenden Ausrichten der Halbleiterscheibe vorhanden sind, welche weitere Düsenbohrungen zum Erzeugen eines vom Zentrum nach außen gerichteten hydrodynamischen Unterdrucks und diametral bewegliche Zentrierschrägen umfassen, und wenn ferner das Zentrum von einer drehbaren Halterung gebildet wird, mit deren Hilfe die zu handhabende Halbleiterscheibe nach Maßgabe von Sensorsignalen in eine vorbestimmbare Position bewegt werden kann.

Mit einer derartigen Vorrichtung kann das Handling dünner Wafer automatisiert werden, so dass sowohl das Entnehmen verbogener Dünnwafer als auch das wieder Einlagern derartiger Dünnwafer nicht mehr manuell erfolgen muss. Dadurch verringert sich die Ausschussquote und die Bearbeitungs-Nebenzeiten werden erheblich reduziert.

Wenn die drehbare Halterung ein Futter (Chuck) ist, welches sowohl Vakuumdüsen als auch Bernoullidüsen aufweist, lassen sich die Zentrierungs- und die Spannvorgänge vereinfachen und optimieren, dabei ist es in gleicher Weise vorteilhaft, ob nun das Futter durch ein Schneckengetriebe oder durch ein Riemengetriebe antreibbar ist.

Um die Halbleiterscheiben automatisch handhaben zu können, weist die Haltevorrichtung Zentrierschrägen auf, die das Futter (Chuck) diametral teilweise umgreifen und mittels eines Gelenkgetriebes auseinander- und zusammenfahrbar sind, wobei das Gelenkgetriebe durch einen Hubzylinder und eine Schubstange gebildet wird. Unterstützt wird die automatische Zentrierung durch die konzentrische Anordnung von Bernoullidüsen im Futter (Chuck).

Um die Halbleiterscheiben automatisch ausrichten zu können, werden ferner Sensorsignale durch wenigstens zwei räumlich beabstandete Fühler erzeugt, welche als Sensoren die Kantenlage einer Abflachung der Halbleiterscheibe erfassen können. Diese Abflachung - auch "Flat" genannt - dient der eindeutigen Lagezuordnung der Halbleiterscheibe. Wenn alle Halbleiterscheiben so ausgerichtet sind, dass alle Flats exakt die gleiche Lage zueinander einnehmen, ist die Positionierung der Halbleiterscheiben korrekt.

Von besonderem Vorteil ist es, dass die Beaufschlagung der Vakuumdüsen und der Bernoullidüsen mit Fluid, die Relativbewegungen der Zentrierschrägen, die Drehung des Futters und die Positionierung der Halbleiterscheibe nach Maßgabe der Sensorsignale durch ein Steuerwerk erfolgen, welches nach einem frei vorbestimmbaren Ablaufprogramm arbeitet. Dadurch kann der gesamte Handlingsablauf automatisiert werden.

Mit Hilfe der Figuren soll die Erfindung anhand eines Ausführungsbeispiels noch näher erläutert werden.

Es zeigt
Figur 1 eine Greifvorrichtung in Draufsicht ;
Figur 2 eine Greifvorrichtung mit eingelegter Halbleiterscheibe;
Figur 3 eine Greifvorrichtung mit ausgerichteter Halb-Leiterscheibe.

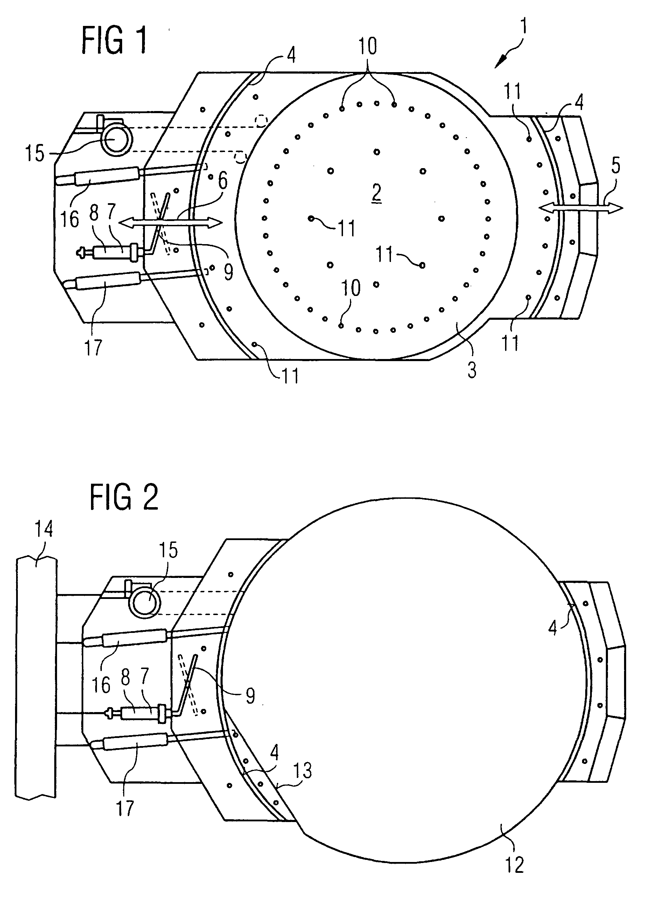

Eine in Figur 1 dargestellte Greifvorrichtung 1 besteht aus mehreren Teilen, die relativ zueinander beweglich sind. Im Zentrum 2 befindet sich eine drehbare Halterung 3, die der Aufnahme von Halbleiterscheiben dient. Am Umfang wird die drehbare Halterung 3 teilweise von Zentrierschrägen 4 umschlossen. Diese Zentrierschrägen 4 sind diametral angeordnet und lassen sich in diametraler Richtung aufeinander zu und voneinander weg bewegen, was durch Richtungs-Pfeile 5 und 6 angedeutet wird. Mittels eines Gelenkgetriebes 7 werden diese lateralen Bewegungen erzeugt, dabei wird das Gelenkgetriebe 7 durch einen Hubzylinder 8 und eine Schubstange 9 realisiert. Die durchgehend gezeigte Schubstange 9 stellt in dieser Figur die Position dar, in welcher sich die Zentrierschrägen 4 in ihrer Zentrierposition befinden.

An der Peripherie der Zentrierschrägen 4 sind Düsenöffnungen angeordnet, die den sogenannten Bernoulli-Effekt erzeugen und als sogenannte Bernoullidüsen 11 zum Tragen der aufzunehmenden Halbleiterscheibe dienen. In der drehbaren Halterung 3 sind in einem äußeren Kreis Vakuumdüsen 10 konzentrisch angeordnet, welche zur Fixierung der Halbleiterscheibe dienen und getrennt von den Bernoullidüsen 11 an der Peripherie der Zentrierschrägen 4 aktiviert werden können. In einem inneren Kreis sind ebenfalls konzentrisch weitere Düsenöffnungen angeordnet, welche ebenfalls den sogenannten Bernoulli-Effekt erzeugen und deshalb auch als Bernoullidüsen 11 bezeichnet werden. Die Bernoullidüsen 11 sind schräg vom inneren Zentrum 2 nach außen gerichtete Bohrungen, durch welche ein Fluid, beispielsweise Luft oder ein anderes Gas geleitet wird. Dieses Fluid bewirkt eine Strömung, welche demgemäss nach außen gerichtet ist und für eine dünne Waferscheibe eine Art Schwebeschicht erzeugt, durch welche die dünne Waferscheibe geebnet wird und auf welcher sie verhältnismäßig stabil schwebend getragen wird. Bei gleichzeitiger Einschaltung der erwähnten Vakuumdüsen 10 wird die Lage der Waferscheibe noch zusätzlich stabilisiert.

Die Zentrierschrägen 4 dienen zur Zentrierung der Waferscheibe, indem durch die gemeinsame Einwirkung des Bernoulli-Effekts und des Vakuum die Waferscheibe über die schrägen Flächen der Zentrierschrägen 4 die Waferscheibe ins Zentrum 2 der Greifvorrichtung 1 gezogen wird.

Wenn die Waferscheibe auf diese Weise zentriert worden ist, nimmt sie eine Lage ein, wie es in der Figur 2 dargestellt ist. Die in Figur 2 gezeigte Anordnung einer Waferscheibe 12 auf einer erfindungsgemäßen Greifvorrichtung 1 macht eine Situation deutlich, welche den Schritten a. und b. des ersten Anspruches entspricht. Die Anordnung bestehend aus Greifvorrichtung 1 und Waferscheibe 12 befindet sich bei dem automatischen Waferhandling dabei noch in dem eingangs erwähnten Materialträger, beispielsweise einer nicht dargestellten Horde.

In einem nächsten Schritt, welcher dem Schritt c. des Anspruches 1 entspricht, wirkt im Wesentlichen nur noch der Unterdruck durch die Vakuumdüsen 10 in der drehbaren Halterung 3 und die Luft der Bernoullidüsen 11 in der drehbaren Halterung 3 und an der Peripherie der Zentrierschrägen 4 unterstützt die Waferscheibe 12. Die Waferscheibe 12 ist dadurch auf der drehbaren Halterung 3 fixiert, die Zentrierschrägen 4 werden gemäß Schritt d. auseinander gefahren und geben den Umfang der Waferscheibe 12 frei, wobei die Bernoullidüsen 11 die Reibung zwischen den Zentrierschrägen 4 und der Waferscheibe 12 weiter reduzieren. Die Waferscheibe 12 ist also bis auf die vakuumbedingte Fixierung auf der drehbaren Halterung 3 völlig frei und befindet sich in Bezug auf eine Abflachung (Flat) 13 am Umfang der Waferscheibe 12 in einer undefinierten Position relativ zur Greifvorrichtung 1.

Gesteuert von einem Steuerwerk 14 wird nach Maßgabe eines Programms die drehbare Halterung 3 mittels eines Riemengetriebes 15 (siehe auch Figur 1) gedreht, wobei die Drehung durch Fühler 16 und 17 erfasst wird, welche die Abflachung 13 am Umfang der Waferscheibe 12 detektieren. Die durch die Freigabe der Zentrierschrägen 4 beliebig mit der Halterung 3 drehbare Halbleiterscheibe (Waferscheibe) 12 rotiert und ihre Abflachung 13 bewegt sich irgendwann im Laufe einer Umdrehung zuerst an einem der Sensoren 16 oder 17 vorbei, die Abflachung 13 wird erfasst und der entsprechende Sensor 16 oder 17 gibt ein Signal an das Steuerwerk 14 ab. Das Steuerwerk 14 gibt nach Maßgabe seines Steuerprogramms einen Steuerbefehl an den Riemenantrieb 15 und die Drehgeschwindigkeit der Halterung 3 mit dem Wafer 12 wird soweit reduziert, dass beim Detektieren der Abflachung 13 des Wafers 12 durch den zweiten Sensor 17 oder 16 die Waferdrehung gestoppt wird. Dies geschieht aufgrund eines weiteren Signals, welches vom entsprechenden Sensor 17 oder 16 an das Steuerwerk 14 übertragen wird, welches wiederum in an sich bekannter Weise ein Stoppsignal generiert, das die rotierende Halterung 3 und damit den Wafer 12 stillsetzt.

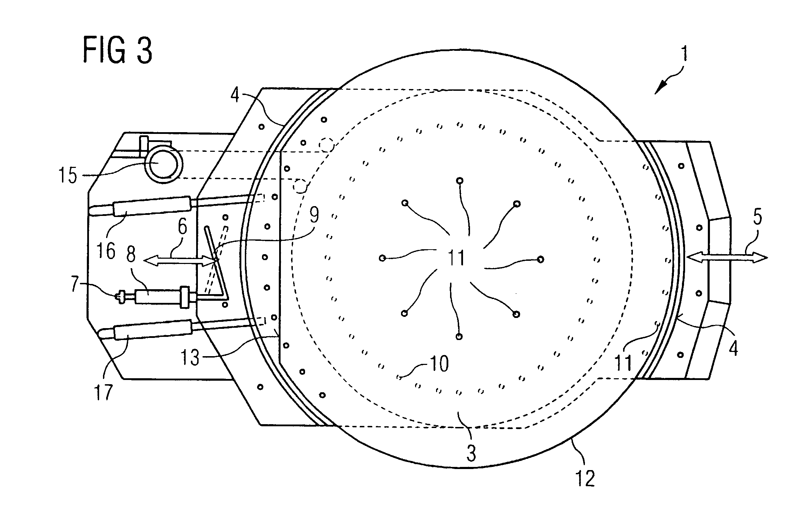

Der Wafer 12 befindet sich nun in seiner gewünschten Position, die als "Sollposition" bezeichnet werden kann. Diese Sollposition des Wafers 12 ist in der Darstellung in Figur 3 gezeigt. In dieser Konstellation wird der Wafer 12 mit Hilfe der Greifvorrichtung 1 gemäß Merkmalsschritt h. des Anspruchs 1 zurück in seine vorerwähnte, aber nicht explizit dargestellte Horde transportiert. Selbstverständlich kann er auch an jedem anderen gewünschten Ort abgelegt werden. Jedenfalls ist er in dieser Konstellation sowohl bezüglich seiner Sollposition als auch bezüglich seiner Ebenheit für die weiteren Bearbeitungsschritte fertig vorbreitet.

### Bezugszeichenliste

- 1.: Greifvorrichtung
- 2.: Zentrum
- 3.: Halterung, drehbar
- 4.: Zentrierschrägen
- 5.: Richtungs-Pfeil
- 6.: Richtungs-Pfeil
- 7.: Gelenkgetriebe
- 8.: Hubzylinder
- 9.: Schubstange
- 10.: Vakuumdüsen
- 11.: Bernoullidüsen
- 12.: Waferscheibe = Halbleiterscheibe
- 13.: Abflachung = Flat
- 14.: Steuerwerk
- 15.: Riemengetriebe
- 16.: Fühler = Sensor
- 17.: Fühler = Sensor

## Patentansprüche

1. Verfahren zum selbsttätigen Handhaben von dünnen Scheiben, insbesondere von Dünnwafern bei der Be- und/oder Entladung von Materialträgern, mittels eines Handhabungsautomaten, das die folgenden Schritte umfasst:
a. eine Greifvorrichtung (1) fährt im Wesentlichen parallel zu einer Scheibe (12) in den Materialträger;
b. mittels pneumatischer Hilfe wird die Scheibe (12) geebnet und durch Zentrierelemente (4, 11) in der Greifvorrichtung (1) zentriert;
c. mittels Vakuum wird die Scheibe (12) in der Greifvorrichtung (1) auf einer Halterung (3) fixiert;
d. die Zentrierelemente (4,) werden von der Scheibe (12) gelöst;
e. mittels Halterung (3) wird die Scheibe (12) gedreht;
f. die Position der Scheibe (12) wird durch Sensoren (16, 17) erfasst;
g. bei Erreichen einer vorbestimmbaren Position wird die Drehung der Scheibe (12) gestoppt;
h. die geebnete und exakt positionierte Scheibe (12) wird in einem Materialträger beliebiger Art abgelegt.

2. Verfahren nach Anspruch 1, **dadurch gekennzeichnet, dass** die Erfassung der Drehung der Scheibe (12) durch mehrere als Fühler ausgebildete Sensoren (16, 17) sukzessive erfolgt.

3. Verfahren nach Anspruch 1 oder 2, dadurch gekennzeichnet, dass die Drehung der Scheibe (12) in unterschiedlichen Geschwindigkeiten erfolgt, wobei die Geschwindigkeit von Signalen der Sensoren (16, 17) abhängig ist.

4. Vorrichtung zur Durchführung des Verfahrens nach einem der vorstehenden Ansprüche mit einer Haltevorrichtung zum Handhaben einer Scheibe, insbesondere mit einer Greifvorrichtung, die mehrteilig ausgeführt ist und zumindest im Zentrum (2) Düsenbohrungen (10) zum hydrodynamischen Halten einer Halbleiterscheibe (12) aufweist und deren Zentrum (2) von einer drehbaren Halterung gebildet wird, mit deren Hilfe die zu handhabende Halbleiterscheibe (12) nach Maßgabe von Sensorsignalen in eine vorbestimmbare Position bewegt werden kann, **dadurch gekennzeichnet, dass** Zentrierelemente (4, 11) zum zentrierenden Ausrichten der Halbleiterscheibe (12) vorhanden sind, welche weitere Düsenbohrungen (11) zum Erzeugen eines vom Zentrum nach außen gerichteten hydrodynamischen Unterdrucks und diametral bewegliche Zentrierschrägen (4) umfassen.

5. Vorrichtung nach Anspruch 4, **dadurch gekennzeichnet, dass** die drehbare Halterung (3) ein Futter ist, welches sowohl Vakuumdüsen (10) als auch Bernoullidüsen (11) aufweist.

6. Vorrichtung nach Anspruch 4, **dadurch gekennzeichnet, dass** das Futter (3) durch ein Schneckengetriebe antreibbar ist.

7. Vorrichtung nach Anspruch 4, **dadurch gekennzeichnet, dass** das Futter (3) durch ein Riemengetriebe (15) antreibbar ist.

8. Vorrichtung nach Anspruch 4, **dadurch gekennzeichnet, dass** die Zentrierschrägen (4) das Futter (3) diametral teilweise umgreifen und mittels eines Gelenkgetriebes (7) auseinander und zusammenfahrbar sind.

9. Vorrichtung nach Anspruch 4, **dadurch gekennzeichnet, dass** das Gelenkgetriebe (7) durch einen Hubzylinder (8) und eine Schubstange (9) gebildet wird.

10. Vorrichtung nach Anspruch 9, **dadurch gekennzeichnet, dass** der Hubzylinder (8) als Pneumatikzylinder ausgebildet ist.

11. Vorrichtung nach Anspruch 4, **dadurch gekennzeichnet, dass** die Sensorsignale durch wenigstens zwei räumlich beabstandete Fühler erzeugt werden, welche als Sensoren (16, 17) die Kantenlage einer Abflachung (13) der Halbleiterscheibe (12) erfassen können.

12. Vorrichtung nach Anspruch 4, **dadurch gekennzeichnet, dass** die Vakuumdüsen (10) und die Bernoullidüsen (11) getrennt mit Fluid beaufschlagt werden können.

13. Vorrichtung nach Anspruch 4, **dadurch gekennzeichnet, dass** die Beaufschlagung der Vakuumdüsen (10) und der Bernoullidüsen (11) mit Fluid, die Relativbewegungen der Zentrierschrägen (4), die Drehung des Futters (3) und die Positionierung der Halbleiterscheibe (12) nach Maßgabe von Signalen der Sensoren (16, 17) durch ein Steuerwerk (14) erfolgen welches nach einem vorbestimmbaren Ablaufprogramm arbeitet.

14. Vorrichtung nach Anspruch 4, **dadurch gekennzeichnet, dass** die Greifvorrichtung (1) in einen Handhabungsautomaten integrierbar ist.

## Claims

1. Method for the automatic handling of thin discs, in particular thin wafers during the loading and/or unloading of material carriers, by means of an automatic handling machine, which comprises the following steps:
a. a grippirg apparatus (1) moves into the material carrier substantially parallel to a wafer (12);
b. by means of pneumatic aid, the wafer (12) is levelled and centred in the gripping apparatus (1) by means of centring elements (4, 11);
c. by means of vacuum, the wafer (12) is fixed in the gripping apparatus (1) on a mount (3);
d. the centring elements (4) are released from the wafer (12);
e. the wafer (12) is rotated by means of the mount (3);
f. the position of the wafer (12) is registered by sensors (16, 17);
g. when a predeterminable position is reached, the rotation of the wafer (12) is stopped;
h. the levelled and exactly positioned wafer (12) is deposited in a material carrier of any desired type.

2. Method according to Claim 1, **characterized in that** the rotation of the wafer (12) is registered successively by means of a plurality of sensors (16, 17) formed as feelers.

3. Method according to Claim 1 or 2, **characterized in that** the rotation of the wafer (12) is carried out at different speeds, the speed depending on signals from the sensors (16, 17).

4. Apparatus for carrying out the method according to one of the preceding claims, comprising a holding apparatus for handling a wafer, in particular comprising a gripping apparatus which is constructed in many parts and, at least at the centre (2), has nozzle holes (10) for holding the semiconductor wafer (12) hydrodynamically, and its centre (2) is formed by a rotatable mount, with the aid of which the semiconductor wafer (12) to be handled can be moved into a predeterminable position in accordance with sensor signals, **characterized in that** there are centring elements (4, 11) for the centred alignment of the semiconductor wafer (12), which comprise further nozzle holes (11) for producing a hydrodynamic vacuum oriented from the centre to the outside, and centring bevels (4) that can be moved diametrically.

5. Apparatus according to Claim 4, **characterized in that** the rotatable mount (3) is a chuck which has both vacuum nozzles (10) and Bernoulli nozzles (11).

6. Apparatus according to Claim 4, **characterized in that** the chuck (3) can be driven by a worm gear mechanism.

7. Apparatus according to Claim 4, **characterized in that** the chuck (3) can be driven by a belt mechanism (15).

8. Apparatus according to Claim 4, **characterized in that** the centring bevels (4) partly enclose the chuck (3) diametrically and can be driven apart and together by means of an articulated mechanism (7).

9. Apparatus according to Claim 4, **characterized in that** the articulated mechanism (7) is formed by a reciprocating cylinder (8) and a push rod (9).

10. Apparatus according to Claim 9, **characterized in that** the reciprocating cylinder (8) is formed as a pneumatic cylinder.

11. Apparatus according to Claim 4, **characterized in that** the sensor signals are generated by means of at least two physically spaced apart feelers which, as sensors (16, 17), can register the edge position of a flat (13) of the semiconductor wafer (12).

12. Apparatus according to Claim 4, **characterized in that** the vacuum nozzles (10) and the Bernoulli nozzles (11) can be acted on separately with fluid.

13. Apparatus according to Claim 4, **characterized in that** the application of fluid to the vacuum nozzles (10) and the Bernoulli nozzles (11), the relative movements of the centring bevels (4), the rotation of the chuck (3) and the positioning of the semiconductor wafer (12) are carried out in accordance with signals from the sensors (16, 17) by a control mechanism (14) which operates in accordance with a predeterminable sequence program.

14. Apparatus according to Claim 4, **characterized in that** the gripping apparatus (1) can be integrated in an automatic handling machine.

## Revendications

1. Procédé pour manipuler automatiquement des plaquettes minces, en particulier des tranches minces, lors du chargement ou du déchargement sur des porte-matériau à l'aide d'un système automatique de manipulation ; le procédé comprend les étapes suivantes :
a) un dispositif de préhension (1) se déplace sensiblement parallèlement à une plaquette (12) dans le porte-matériau,
b) par des moyens pneumatiques, la plaquette (12) est aplanie et elle est centrée dans le dispositif de préhension (1) par des éléments de centrage (4, 11),
c) la plaquette (12) dans le dispositif de préhension (1) est immobilisée sur un support (3) à l'aide du vide,
d) les éléments de centrage (4, 11) sont détachés de la plaquette (12),
e) la plaquette (12) est tournée à l'aide du support (3),
f) la position de la plaquette (12) est détectée par des détecteurs (16, 17),
g) la rotation de la plaquette (12) est arrêtée lorsqu'elle atteint une position prédéterminable,
h) la plaquette (12), aplanie et exactement placée, est déposée dans un porte-matériau de type quelconque.

2. Procédé selon la revendication 1, **caractérisé en ce que** la rotation de la plaquette (12) est détectée par plusieurs détecteurs (16, 17) conçus sous forme de palpeurs.

3. Procédé selon la revendication 1 ou 2, **caractérisé en ce que** la rotation de la plaquette (12) a lieu à des vitesses différentes, la vitesse dépendant de signaux des détecteurs (16, 17).

4. Dispositif pour exécuter le procédé selon l'une des revendications précédentes à l'aide d'un dispositif porteur destiné à manipuler une plaquette, en particulier à l'aide d'un dispositif de préhension ; le dispositif comporte plusieurs parties et, au moins au centre (2), présente des perçages de buse (10) destinés à supporter de façon hydrodynamique une plaquette semi-conductrice (12) et dont le centre (2) est formé par un support tournant à l'aide duquel la plaquette semi-conductrice (12) à manipuler peut être déplacée dans une position prédéterminable d'après les indications des signaux de détections, **caractérisé en ce qu'**il existe des éléments de centrage (4, 11) qui servent à orienter de façon centrée la plaquette semi-conductrice (12) et qui comprennent d'autres perçages de buse (11) destinés à produire une dépression orientée du centre vers l'extérieur et des inclinaisons de centrage (4) mobiles et diamétralement opposées.

5. Dispositif selon la revendication 4, **caractérisé en ce que** le support (3) tournant est un mandrin muni aussi bien de buses à vide (10) que de buses de Bernoulli (11).

6. Dispositif selon la revendication 4, **caractérisé en ce que** le mandrin (3) peut être entraîné par un engrenage à vis sans fin.

7. Dispositif selon la revendication 4, **caractérisé en ce que** le mandrin (3) peut être entraîné par un mécanisme à courroie (15).

8. Dispositif selon la revendication 4, **caractérisé en ce que** les inclinaisons de centrage (4) entourent en partie diamétralement le mandrin (3) et peuvent être écartées et rassemblées à l'aide d'un mécanisme articulé (7).

9. Dispositif selon la revendication 4, **caractérisé en ce que** le mécanisme articulé (7) est formé par un vérin de levage (8) et par une bielle (9).

10. Dispositif selon la revendication 9, **caractérisé en ce que** le vérin de levage (8) est un vérin pneumatique.

11. Dispositif selon la revendication 4, **caractérisé en ce que** les signaux de détection sont produits par au moins deux palpeurs, à distance l'une de l'autre, qui en tant que détecteurs (16, 17) peuvent détecter la façon dont sont placées les arêtes d'un aplatissement (13) de la plaquette semi-conductrice (12).

12. Dispositif selon la revendication 4, **caractérisé en ce que** les buses à vide (10) et les buses de Bernoulli (11) peuvent être alimentées séparément par un fluide.

13. Dispositif selon la revendication 4, **caractérisé en ce que** les buses à vide (10) et les buses de Bernoulli (11) sont alimentées en fluide, les inclinaisons de centrage (4) ont des mouvements relatifs, le mandrin (3) tourne et la plaquette semi-conductrice (12) est disposée selon les indications des signaux des détecteurs (16, 17) au moyen d'une unité de commande (14) qui fonctionne d'après un programme qu'on peut librement prédéfinir.

14. Dispositif selon la revendication 4, **caractérisé en ce que** le dispositif de préhension (1) peut être intégré dans un appareil automatique de manipulation.
